(19) Europäisches Patentamt
European Patent Office
Office européen des brevets

(11) EP 2 180 301 A2

(12) **EUROPEAN PATENT APPLICATION**

(43) Date of publication:
**28.04.2010 Bulletin 2010/17**

(51) Int Cl.:
***G01J 9/02*** *(2006.01)*

(21) Application number: **09173968.0**

(22) Date of filing: **23.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **24.10.2008 JP 2008274213**
**28.09.2009 JP 2009223435**

(71) Applicant: **Canon Kabushiki Kaisha**
**Tokyo 146-8501 (JP)**

(72) Inventor: **Ishizuka, Ko**
**Ohta-ku Tokyo (JP)**

(74) Representative: **Foxon, Rachel Siobhan**
**Canon Europe Ltd**
**European Patent Department**
**3 The Square**
**Stockley Park**
**Uxbridge, Middlesex UB11 1ET (GB)**

(54) **Wavelength shift measuring apparatus, optical source apparatus, interference measuring apparatus, exposure apparatus, and device manufacturing method**

(57) A wavelength shift measuring apparatus of the present invention is a wavelength shift detector (WLCD1) which measures a shift of a wavelength of a light beam emitted from a light source, and includes a beam splitter (BS2) splitting the light beam emitted from the light source into a plurality of light beams and to synthesize two light beams among the plurality of light beams to generate an interference light, a spacer member (SP) provided so that an optical path length difference of the two light beams split by the beam splitter (PBS2) is constant, and a plurality of photoelectric sensors (PD) detecting the interference light generated by the beam splitter (BS2). The plurality of photoelectric sensors (PD) output a plurality of interference signals having phases shifted from one another based on the interference light to measure a wavelength shift using the plurality of interference signals.

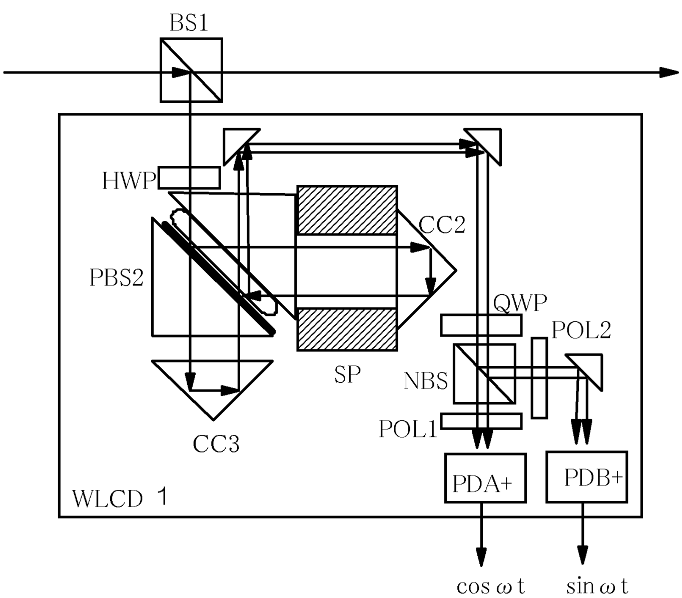


FIG. 3

EP 2 180 301 A2

## Description

BACKGROUND OF THE INVENTION

Field of the Invention

The present invention relates to a wavelength shift measuring apparatus capable of measuring a shift of a light source wavelength by being configured so that an optical path length difference of two light beams is constant.

Description of the Related Art

Conventionally, an interferometer has been used as a measuring apparatus for measuring a relative displacement or a refractive index of a machine stage. The interferometer generally measures with reference to a wavelength. Therefore, when a wavelength of the light source shifts, a measurement error is generated.

In this regard, conventionally, either (1) or (2) method has been used, i.e. (1) a configuration where an optical path length difference is set to zero is adopted so as not to generate an error caused by a light source wavelength shift in principle, or (2) a wavelength stabilization laser is used for suppressing a measurement error.

However, for example in order to suppress a measurement error in an interference measuring apparatus where an optical path length difference can not be set to zero for the intended use, there is no other way than to stabilize a wavelength. For example, Japanese Patent Laid-open No. 2002-319737 describes an optical communication light source where a wavelength stabilizing function is embedded. However, as described in Japanese Patent Laid-open No. 2003-202203, because the wavelength stabilization laser is expensive, the measuring apparatus can not be configured at low cost.

Japanese Patent Laid-open No. 2006-010499 discloses a wavelength determination device having a configuration where a tilt is given to the optical path length difference by a wedge plate or the like and an interference pattern is generated by the interference of reflected lights on front and back surfaces. Further, it discloses that a light receiving element is disposed considering a bright and dark distribution of the interference pattern and that change of the bright and dark positions in accordance with the wavelength shift is detected by the fixed light receiving element. Japanese Patent Laid-open No. 2006-010499 proposes that the wavelength shift is detected with high resolution by the configuration.

However, commonly, a thickness of the wedge plate can not be accurate in a size around a wavelength. Therefore, the adjustment and the installation is necessary so as to be able to perform the most sensitive detection of the change of the bright and dark in accordance with the relation between the positions of the light receiving element and the interference pattern. However, the displacement of such areas may be affected by the external environment (temperature variation, application of vibration, or the like), and further stabilization is necessary. In the wedge plate made of a glass or the like, because the optical path length difference of the front and back surfaces varies by the influence of heat expansion, a method for reducing the influence of heat expansion is also required.

SUMMARY OF THE INVENTION

The present invention includes a configuration where an optical path length difference of two light beams is constant, and is configured so that a phase of an interference signal is not influenced by external elements (such as temperature, humidity, vibration, or the like) so is only influenced by a wavelength shift. Therefore, an inexpensive and highly-accurate wavelength shift measuring apparatus which is capable of stably accurately measuring a shift of a light source wavelength is provided. Furthermore a light source apparatus, an interference measuring apparatus, an exposure apparatus, and a device manufacturing method using the wavelength shift measuring apparatus is also provided.

The present invention in its first aspect provides a wavelength shift measuring apparatus as specified in claims 1 to 4.

The present invention in its second aspect provides a light source apparatus as specified in claim 5.

The present invention in its third aspect provides an interference measuring apparatus as specified in claim 6.

The present invention in its fourth aspect provides an exposure apparatus as specified in claim 7.

The present invention in its fifth aspect provides a device manufacturing method as specified in claim 8.

Further features and aspects of the present invention will become apparent from the following description of exemplary embodiments with reference to the attached drawings.

BRIEF DESCRIPTION OF THE DRAWINGS

Fig. 1 is a block diagram of an interference measuring apparatus in the present embodiment.

Fig. 2 is a block diagram of another interference measuring apparatus in the present embodiment.

Fig. 3 is a configuration diagram of a wavelength shift detector WLCD1 (wavelength shift measuring apparatus) in Embodiment 1.

Fig. 4 is a configuration diagram of a wavelength shift detector WLCD2 (wavelength shift measuring apparatus) in Embodiment 2.

Fig. 5 is a configuration diagram of diffraction gratings GBS1 to GBS4 and a photoelectric sensor PD in Embodiment 2.

Fig. 6 is a configuration diagram of a diffraction grating GBS4 in Embodiment 2.

Fig. 7 is a flow of a method for manufacturing a wavelength shift detector in Embodiment 2.

Fig. 8 is a flow of a method for manufacturing another wavelength shift detector in Embodiment 2.

Fig. 9 is a configuration diagram of a wavelength shift detector WLCD3 (wavelength shift measuring apparatus) in Embodiment 3.

Fig. 10 is a schematic configuration diagram of an exposure apparatus of the present embodiment.

## DESCRIPTION OF THE EMBODIMENTS

Exemplary embodiments of the present invention will be described below with reference to the accompanied drawings. In each of the drawings, the same elements will be denoted by the same reference numerals and the duplicate descriptions thereof will be omitted.

First, a configuration of an interference measuring apparatus of the present embodiment will be described. Fig. 1 is a block diagram of an interference measuring apparatus of the present embodiment.

A light source LD emits a coherent light beam. The light beam emitted from the light source LD enters a beam splitter BS1 and part of the light beam transmits through the beam splitter BS1 and is guided to a interference measuring portion (interferometer) where it is used for measuring a position and displacement of an object to be measured.

As shown in Fig. 1, the interference measuring portion of the interference measuring apparatus of the present embodiment includes a beam splitter BS, corner cubes CC0 and CC1, a photoelectric sensor PDO (photodetector), and an processor PROCESSOR1.

The interference measuring portion measures a displacement (position) of the corner cube CC1 (object to be measured) which is fixedly disposed on a movable stage STG where the stage is movable in the direction of the arrow shown in Fig. 1. Such an interference measuring portion is used for measuring a displacement or a refractive index of the object to be measured, or the like. The interference measuring portion is not limited to being configured as a Michelson interferometer as shown in Fig. 1 but may be configured, for example, as a Fizeau interferometer or a Mach-Zehnder interferometer.

In the interference measuring portion, part of an incident light beam which has entered the beam splitter BS is reflected by the beam splitter BS to enter the corner cube CC0. The other part of the incident light beam transmits through the beam splitter BS to enter the corner cube CC1 disposed on the movable stage STG. Two light beams from the corner cubes CC0 and CC1 are synthesized by the beam splitter BS to be converted into an electric signal via the photoelectric sensor PDO. An output signal from the photoelectric sensor PDO is inputted to the processor PROCESSOR1 by which a displacement of the stage STG is calculated.

The interference measuring apparatus is not limited to the configuration shown in Fig. 1, but can be appropriately modified in accordance with the intended use.

Part of the light beam emitted from the light source LD enters the beam splitter BS1 and is reflected by the beam splitter BS1. The reflected light beam is guided to a wavelength shift detector WLCD. Thus, the beam splitter BS1 functions as a light beam splitting portion which splits the light beam emitted from the light source LD.

The wavelength shift detector WLCD detects a relative shift with respect to an initial value of a light source wavelength (a wavelength of a light beam emitted from the light source LD). Thus, the wavelength shift detector WLCD also referred to herein as a wavelength shift measuring apparatus receives the other part of the light beam emitted from the light source LD and outputs an interference phase shift signal of the light beam (interference signal).

The wavelength shift detector WLCD is constituted of an interference phase measuring optical system and is configured to output a plurality of interference signals. The plurality of interference signals outputted from the wavelength shift detector WLCD are guided to a subsequent processor PROCESSOR2, and a wavelength shift is calculated by the processor PROCESSOR2. The processor PROCESSOR2 may also be included in the wavelength shift detector WLCD.

In the interference measuring apparatus shown in Fig. 1 the wavelength shift calculated by the processor PROCESSOR2 is fed back to a controller which controls one or more of, for example, a driving current, a temperature of the light source LD, a position controlling portion of a diffraction grating or a mirror inside the light source to perform a control so that the wavelength shift keeps an original value (so that the wavelength shift is reduced). Specifically, in order to perform the feedback control as described above, the driving portion DRIVER controls the operation of the light source LD based on an output signal from the processor PROCESSOR2.

Thus, the interference measuring apparatus has a controller which, in this particular embodiment, controls the driving current and the temperature of the light source LD so that the wavelength shift of the light emitted from the light source LD is suppressed, based on the interference phase shift signal outputted from the wavelength shift measuring apparatus WLCD. In this particular embodiment, the controller includes the processor PROCESSOR2 and the driving portion DRIVER.

In the interference measuring apparatus shown in Fig. 1, the light source LD, the beam splitter BS1, the wavelength shift measuring apparatus WLCD, the processor PROCESSOR2, and the driving portion DRIVER in combination function as a light source apparatus.

Thus, in the interference measuring apparatus shown in Fig. 1, the wavelength shift detector WLCD detects the wavelength shift of the light source LD and the processor PROCESSOR2 and the driving portion DRIVER control the operation of the light source LD so that the wavelength shift is reduced. The generation of the wavelength shift of the light beam emitted from the light source LD can be suppressed by such a control and the light source wavelength can be stabilized.

Next, the configuration of another embodiment of an interference measuring apparatus will be described. Fig. 2 is a block diagram of another embodiment of an interference measuring apparatus.

The interference measuring apparatus shown in Fig. 2 outputs the interference phase shift signal from the wavelength shift detector WLCD as light source wavelength information to a subsequent processor PROCESSOR. The processor PROCESSOR includes a wavelength shift calculating portion which calculates a shift of the wavelength of the light beam based on the light source wavelength information in the form of an interference phase shift signal outputted from the wavelength shift detector WLCD.

The processor PROCESSOR calculates a relative displacement of an object to be measured based on the interference signal (for example, change of an interference pattern, information of an interference phase, and latest information of the wavelength) which is obtained by the interference measuring portion of the interference measuring apparatus. Further, the processor PROCESSOR is provided with a displacement correcting portion. The displacement correcting portion corrects the measured displacement of the object which has been measured by the main interference measuring apparatus (interference measuring portion) using the shift of the wavelength calculated by the wavelength shift calculating portion. In the embodiment an error corresponding to a wavelength shift is calculated to obtain a precise wavelength. Thus, the displacement can be obtained based on the precise wavelength.

Functions of the processor PROCESSOR shown in Fig. 2 can be included in an upper apparatus of the interference measuring apparatus. In this case, for example, arithmetic wavelength information, a count value of an interference pattern, and phase information are outputted from the processor PROCESSOR.

Next, the configuration of the wavelength shift detector provided in the interference measuring apparatus of the present embodiment will be described in detail.

[Embodiment 1]

First, a wavelength shift detector in Embodiment 1 will be described.

Fig. 3 is a configuration diagram of a wavelength shift detector WLCD1 in the present embodiment. The wavelength shift detector WLCD1 (wavelength shift measuring apparatus) shown in Fig. 3 is constituted by using a polarization beam splitter.

The wavelength shift detector WLCD1 includes a half-wave plate HWP, a polarizing beam splitter PBS2, corner cubes CC2 and CC3, and a quarter-wave plate QWP, a non-polarizing beam splitter NBS, a polarization plate POL1, and a polarization plate POL2 as optical elements (optical system). Further, it includes a spacer member SP, a photoelectric sensor PDA+, and a photoelectric sensor PDB+.

A polarization plane of the light beam reflected by the beam splitter BS1 is appropriately rotated by the half-wave plate HWP in accordance with an initial direction of a linear polarization to set the polarization plane to 45 degrees direction to enter the polarization beam splitter PBS2. The incident light beam which has entered the polarization beam splitter PBS2 is split into two light beams constituted of reflected light of S-polarization and transmitted light of P-polarization.

The reflected light of S-polarization enters the corner cube CC2, and the transmitted light of P-polarization enters the corner cube CC3.

The two light beams that have entered the corner cubes CC2 and CC3 are reflected by the corner cubes CC2 and CC3 to enter the polarization beam splitter PBS2 again to be synthesized. Thus, the polarization beam splitter PBS2 initially splits the light beam emitted from the light source into two light beams and ultimately synthesizes the two light beams. Although the two light beams do not interfere because they have polarization planes orthogonal to each other, after the light beams transmit through the quarter wavelength plate QWP, they are converted into linear polarization light beams which change the directions of the polarization planes in accordance with the phase difference between the light beams to be split into homogeneous two light beams by the non-polarization beam splitter NBS. An interference pattern is provided to the transmitted light by the polarization plate POL1, and the transmitted light enters a photoelectric element PDA+ as a cosine signal light (A-phase signal). On the other hand, an interference pattern is provided to the reflected light by the polarization plate POL2, and the reflected light enters a photoelectric element PDB+ as a sine signal light (B-phase signal).

In the present embodiment, a spacer member SP is provided so that an optical path length difference of the two light beams split by the polarization beam splitter PBS2 is constant. Specifically, the spacer member SP maintains a constant interval between the beam splitter BS2 and the corner cube CC2.

A plurality of photoelectric sensors PDA+ and PDB+ output interference phase shift signals (interference signals) based on the incident interfering light beams. The phases of the interference signals are shifted by 90 degrees with respect to each other. The interference phase shift signals are inputted to an processor (not shown), and a wavelength shift is calculated. The processor performs an arctangent calculation ($\tan^{-1}$) using the A-phase signal and the B-phase signal to calculate an interference phase φ. When the interference phase φ is continuously measured, the shift of the interference phase φ can be obtained. Therefore, the shift of the light source wavelength can be measured.

In the wavelength shift detector WLCD1 of the present embodiment, the beam splitter BS2 and the corner cubes CC2 and CC3 are configured so that an optical path length difference of two light beams is maintained by using the stable spacer member SP. Generally, when an optical path length difference is $L_0$ [nm], an initial wavelength of a light source is $\lambda_0$ [nm], and a wavelength shift is $\Delta\lambda$ [nm], a phase shift $\Delta\varphi$ [rad] is represented as expression (1).

$$\Delta\varphi = 2\pi\times L_0\times\{1/\lambda_0-1/(\lambda_0+\Delta\lambda)\} \quad \ldots \; (1)$$

When the expression (1) is rearranged and $\Delta\lambda$ is approximated as $\Delta\lambda \ll \lambda_0$ , the expression (1) is represented as expression (1').

$$\Delta\lambda = (\Delta\varphi\times\lambda_0^{2})/(2\pi\times L_0) \quad \ldots \; (1')$$

In the expression (1'), substituting 10000μm as $L_0$, 1/4096 as $\Delta\varphi/2n$, and 0.85μm as $\lambda_0$ into the expression (1'), $\Delta\lambda$ is 0.017pm. The wavelength shift $\Delta\lambda$ corresponds to a wavelength shift detection resolution. In other words, the calculation of wavelength shift from phase shift can be performed using the relation that "a wavelength shift of 0.017pm corresponds to a phase shift of (1/4096)×2n".

As described above, according to the wavelength shift measuring apparatus of the present embodiment, because a stable spacer member is used so that the optical path length difference of two light beams is held to be constant, a wavelength shift of the light source can be calculated with high accuracy. Further, an internal space of the spacer is preferably evacuated or filled with dry air in order to remove humidity dependency.

[Embodiment 2]

Next, a wavelength shift detector in Embodiment 2 of the present invention will be described.

Fig. 4 is a configuration diagram of a wavelength shift detector WLCD2 (wavelength shift measuring apparatus) according to the present embodiment. In the wavelength shift detector WLCD2 (wavelength shift measuring apparatus) shown in Fig. 4, a spacer member SP is held between two diffraction grating plates (glass substrates G1 and G2: transmissive substrate). Thus, the spacer member SP that is a reference of an optical path length difference of the two light beams is used so as to constitute a wavelength shift detector of a Mach-Zehnder interferometer which forms the optical path length difference of the two light beams. The wavelength shift detector can be used as a Mach-Zender interferometer.

The wavelength shift detector WLCD2 shown in Fig. 4 is provided with a transmissive diffraction grating GBS1 and a reflective diffraction grating GBS3 (collectively, a "first diffraction grating") on a back surface of a glass substrate G1 (first diffraction grating plate) as an optical element (optical system). A glass substrate G2 (second diffraction grating plate) as an optical element (optical system) is arranged so as to face the glass substrate G1 at a distance of an interval (a gap G) formed by the spacer member SP. The glass substrate G2 is provided with a reflective diffraction grating GBS2 and a transmissive diffraction grating GBS4 (collectively, a "second diffraction grating").

The spacer member SP maintains the interval (the gap G) between the glass substrate G1 and the glass substrate G2 so that the difference in optical path length of the two light beams is constant. In the present embodiment, for example the gap G is set to between 5 to 10mm, but is not limited to this.

The spacer member SP is preferably formed using a low-expansion material or in other words a material having a low coefficient of thermal expansion such as glass. For example, when a spacer member SP having a length G of 10mm is formed of a low-expansion material having characteristics of 0.1ppm/degree Celsius, the optical path length difference is 20mm (two times the length of the spacer or gap G) and the optical path length difference varies 2nm by a temperature variation of 1 degree Celsius. If a low-expansion material having characteristics of, for example, 0.02ppm/ degree Celsius is used to form the spacer, the variation of the optical path length difference can be further suppressed. In this case, a control is preferably performed so that a temperature variation is minimised, for example the temperature variation is kept in a range of plus or minus 0.1 degree Celsius. As described in the present embodiment, an optical system which is formed having a spacer member SP extending between and in contact with the diffraction gratings is extremely stable because only the thermal expansion of a material of the spacer member SP has to be considered.

The light beam that has been reflected by the beam splitter BS1 and enters the glass substrate G1 is separated into zero-order and first-order light and other light by the diffraction grating GBS1.

Reflection and first-order diffraction of the zero-order light of the diffraction grating GBS1 are performed by the diffraction grating GBS2, where the diffraction grating GBS2 is formed on an upper surface of the glass substrate G. Reflection and a minus first-order diffraction of the light are then performed by the diffraction grating GBS3, where diffraction grating GBS3 is positioned on a lower surface of the glass substrate G1. The light enters the diffraction grating GBS4, positioned on the upper surface of the glass substrate G2, and transmits through the diffraction grating GBS4 as zero-order light.

On the other hand, transmission and a first-order diffraction of the first-order light from diffraction grating GBS1 are performed by the diffraction grating GBS4, positioned on an upper surface of the glass substrate G2, and the light transmits through the diffraction grating GBS4.

The two light beams transmitted through and synthesized by the diffraction grating GBS4 interfere with each other and enter a plurality of photoelectric sensors PD (photodetectors). For example, two photoelectric sensors PDA+ and PDB+ are shown in Fig. 4. The photoelectric sensor PD outputs an interference phase shift of the light beam based on the detected interference pattern.

Next, configurations of the diffraction grating GBS4 and the photoelectric sensor PD will be described in detail. Fig. 5 is a configuration diagram of the diffraction gratings GBS1 to GBS4 and the photoelectric sensor PD in the present embodiment. Fig. 6 is a configuration diagram of the diffraction grating GBS4 in the present embodiment.

As shown in Fig. 6, the diffraction grating GBS4 includes four regions GBS4-A+, GBS4-B+, GBS4-A-, and GBS4-B-. Each diffraction grating is arranged at a position with a relative shift by 1/4 pitch for each of the four regions. The regions GBS4-A+ and GBS4-A- are configured to have phases opposite to each other, and the regions GBS4-B+ and GBS4-B- are also configured to have phases opposite to each other. The regions GBS4-A+ and GBS4-B+ are configured to have a shift from each other by 1/4 pitch.

First-order diffracted light from the diffraction grating GBS1 changes a position of its wavefront in accordance with a position of the grating when first-order diffraction is performed by each of the four regions of the diffraction grating GBS4. Therefore, wavefront phases of the first-order diffracted light beams emitted from the different regions of the diffracted grating GBS4 have phases shifted from one another by 90 degrees. However, the light beam entered from the diffraction grating GBS3 transmits through the diffraction grating GBS4 without change, and its optical path is overlapped with that of the light beam entered from the diffraction grating GBS1. Thus, the two light beams entered from the diffraction gratings GBS1 and GBS3 interfere with each other.

The photoelectric sensor PD shown in Fig. 5 includes four regions PD-A+, PD-B+, PD-A-, and PD-B-. Each region of the photoelectric sensor PD is arranged so as to correspond to one of the four regions of the diffraction grating GBS4. Therefore, sine-wave signals having phases different from one another by 90 degrees are output from output portions of the four regions PD-A+, PD-B+, PD-A-, and PD-B-.

A processor of the interference measuring apparatus generates an A-phase signal and a B-phase signal based on the four different phase signals outputted from the photoelectric sensor PD. The A-phase signal is a differential signal of the output signal from the two regions PD-A+ and PD-A- of the photoelectric sensor PD. The B-phase signal is a differential signal of the output signals from the other two regions PD-B+ and PD-B- of the photoelectric sensor PD.

The processor performs an arctangent calculation ($\tan^{-1}$) using the A-phase signal and the B-phase signal to calculate an interference phase $\varphi$. A shift of the interference phase $\varphi$ can be obtained by continuous measurement of the interference phase $\varphi$. A shift of the light source wavelength can be calculated from the continuous measurement of the interference phase.

In the wavelength shift detector WLCD2 shown in Fig. 4, similarly to the case of the wavelength shift detector WLCD1 of Fig. 3, the phase shift $\Delta\varphi$ and the wavelength shift $\Delta\lambda$ are represented by the expressions (1) and (1'), respectively. When the optical path length difference $L_0$ is 10000$\mu$m, the phase shift $\Delta\varphi/2\pi$ is 1/4096, and the initial wavelength of the light source $\Delta\lambda$ is 0.85$\mu$m, the wavelength shift $\Delta\lambda$ corresponding to the wavelength shift detection resolution is 0.017pm. In other words, the calculation of wavelength shift from phase shift can be performed using the relation that "a wavelength shift of 0.017pm corresponds to a phase shift of $(1/4096)\times2\pi$"

In the wavelength shift detector WLCD2, grating pitches of the diffraction gratings GBS1, GBS2, GBS3, and GBS4 are set to be the same value. These diffraction gratings have only to have a function of transmission or reflection.

As shown in Fig. 4, the optical path of the light diffracted by the diffraction grating GBS1 passes diagonally across the gap formed by the spacer member SP from GBS1 to the diffraction grating GBS4. On the other hand, the optical path of the light beam transmitted through the diffraction grating GBS1 by zero-order transmission passes from GBS1 to GBS2 along length G before passing diagonally across to GBS3 and again along length G between GBS3 and the diffraction grating GBS4. The diagonal portion of the optical path of the transmitted light has a length similar to the diagonal optical path of the diffracted light passing directly from GBS1 to GBS4. Therefore, the optical path length difference of the two light beams corresponds to a length twice as long as the gap G, and it is an extremely simple configuration. For example, when the length of the gap G is set to 5mm, the optical path length difference of the two light beams is 10mm.

The low-expansion spacer member SP is configured to maintain a gap of width G between the glass substrates G1 and G2. Therefore, there are a few components and the configuration is simple, no adhesives are necessary, and an overall configuration of the wavelength shift detector WLCD2 is extremely stable. A region of the gap G is filled with dry air or the like instead of a glass member. Therefore, there is a little possibility that the length of the gap G changes with the passage of time. The spacer element can be attached to the glass substrate by using adhesives, an external fixing e.g. a clamp, by just disposing the spacer element on the glass substrate, or the like.

As described above, the wavelength shift detector WLCD2 shown in Fig. 4 is superior to the wavelength shift detector WLCD1 of Fig. 3. When considering only a wavelength shift instead of an absolute value of a light source wavelength, the accuracy of the gap G maintained between the glass substrates G1 and G2 by the spacer member SP is not important.

In the wavelength shift detector WLCD2, as a method for providing a phase difference, a wavefront splitting is performed to split the diffraction grating GBS4 into four regions. However, the present invention is not limited to this, and the number of the splitting may be, for example two or three. Because one-order diffracted light shifts a phase of its wavefront in accordance with the position of the diffraction grating, a similar effect can also be obtained by performing the wavefront splitting of any one of the diffraction gratings GBS1, GBS2, and GBS3.

Next, a method for manufacturing the wavelength shift detector in the present embodiment will be described. Fig. 7 is a flow diagram showing the method for manufacturing the wavelength shift detector of the present embodiment.

First, in Step S101, a resist is applied onto one surface of a transmissive substrate (a glass substrate), and an exposure is performed for obtaining diffraction grating patterns with a pitch of around 2μm by using a semiconductor exposure apparatus. Subsequently, the diffraction grating pattern (transmissive) is formed via developing and etching processes.

Next, in Step S102, a metal film such as aluminium is formed at an area where light is to be reflected and diffracted. Commonly, aluminium is evaporated on a whole area, and aluminium is removed from transmissive areas by etching in a photolithography process.

In Step S103, the transmissive substrate (glass substrate) on which the diffraction grating pattern is formed is cut into two diffraction grating plates, each of which preferably has a size of around 5mm×10mm. In Step S104, the two diffraction grating plates are bonded to both sides of the spacer member SP having a frame shape with a thickness of around 5mm in a state where its inside is a diffraction grating pattern surface.

In this case, an angle alignment of the two diffraction grating plates in a mutual azimuth direction is performed, and they are bonded while the contrast of the interference signal is adjusted to be improved. The angles of the two diffraction grating plates are aligned so as to be parallel to each other. When the diffraction grating plate is bonded, adhesive with low moisture absorption and extremely low expansion is preferably adopted.

When a space enclosed by the spacer members SP and the diffraction gratings is connected to the outside, because of the atmospheric pressure variation, humidity variation, or the like, an error may be caused by the change of the density, the refractive index, or the like. Therefore, it is preferable that any exhaust hole portion provided on the spacer member SP is sealed after the air in the space has been evacuated to keep the space in a state closer to a vacuum state or to inject dry air. The wavelength shift detector can also be constituted without using the spacer member SP.

Fig. 8 is a flow of a method for manufacturing another wavelength shift detector in the present embodiment. The flow of Fig. 8 shows a method for forming a diffraction grating on both sides of a glass substrate without using the spacer member SP.

First, in Step S201, a resist is applied onto both surfaces of a thick transmissive substrate (glass substrate) and an exposure is performed for forming diffraction grating patterns with a pitch of around 2μm by using a semiconductor exposure apparatus. Subsequently, the diffraction grating pattern (transmissive) is formed via developing and etching processes.

Next, in Step S202, a metal film such as aluminium is formed at an area where light is to be reflected and diffracted. Commonly, aluminium is evaporated on a whole area, and only aluminium in a transmissive area is removed by etching in a photolithography process. In Step S203, a transmissive substrate on which the diffraction grating pattern is formed is cut into parts, each of which has a size of around 5mm×10mm to use it as a diffraction grating plate.

When a diffraction grating plate is formed without using the spacer member SP, as an alternative to the method shown in Fig. 8, two transmissive substrates may each have a diffraction grating pattern formed on one surface and the two transmissive substrates may be joined by bonding the two surfaces opposite to the diffraction grating patterns.

Because a material that provides an optical path length difference is a transmissive substrate such as a quartz glass, a low-expansion material (quartz) itself may be deteriorated. Therefore, a compensation of a reference optical path length is preferably performed by a temperature measurement.

According to the method for manufacturing the wavelength shift measuring apparatus (diffraction grating plate) in the present embodiment, because an optical system is formed at both sides of the glass substrate, a good shape stability and reliability can be obtained.

As described above, according to the wavelength shift measuring apparatus of the present embodiment, because the optical path length difference of two light beams is held so as to be constant, a wavelength shift of a light source can be measured with high accuracy.

[Embodiment 3]

Next, a wavelength shift measuring apparatus in Embodiment 3 of the present invention will be described.

Fig. 9 is a configuration diagram of a wavelength shift detector WLCD3 (wavelength shift measuring apparatus) in the present embodiment. The wavelength shift detector WLCD3 (wavelength shift measuring apparatus) shown in Fig. 9 is configured to hold a spacer member SP between two diffraction grating plates (glass substrates G3 and G4).

The wavelength shift detector WLCD3 is provided with two diffraction gratings GBS11 and GBS13 (first diffraction grating) and a reflective element R1 (first reflective element) on a glass substrate G11 (first diffraction grating plate) as an optical element (optical system). Similarly, two diffraction gratings GBS12 and GBS14 (second diffraction grating) and a reflective element R2 (second reflective element) are provided on a glass substrate G12 (second diffraction grating plate) as an optical element (optical system).

In the wavelength shift detector WLCD3, the functions of the diffraction gratings GBS11 to GBS14 are similar to those of the diffraction gratings GBS1 to GBS4 of Embodiment 2. However, the glass substrates G11 and G12 in Embodiment 3 are provided with the reflective elements R1 and R2 between two diffraction gratings, respectively.

The reflective element R1 reflects one of the two light beams split by the diffraction grating GBS11. The reflective element R2 reflects the other of the two light beams. In other words, the reflective element R1 reflects the light beam from the reflective diffraction grating GBS12 to the reflective diffraction grating GBS14. The reflective element R2 reflects the light beam from the transmissive diffraction grating GBS11 to the transmissive diffraction grating GBS13.

As shown in Fig. 9, in the wavelength shift detector WLCD3, the optical path length difference of the two light beams is, similarly to the case of the wavelength shift detector WLCD2 of Embodiment 2, twice as long as the interval (gap G) of the spacer member SP.

An interference pattern is generated by synthesizing the light reflected by the reflective element R1 and the light reflected by the reflective element R2 in the diffraction grating GBS13 that is a first diffraction grating to be emitted to the photoelectric sensor PD. In the wavelength shift detector WLCD3 in the present embodiment, the synthesized light (received light) is emitted to the same side as that of incident light. Therefore, the photoelectric sensor PD is provided at the incident light side (the same side as that of the beam splitter BS1).

The diffraction grating GBS13 is, similarly to the diffraction grating GBS4 of Embodiment 2, split into four regions. In the present embodiment, similarly to the case of Embodiment 2, based on the light beams (interference signal) emitted from the four regions, a phase shift $\Delta\varphi$ and a wavelength shift $\Delta\lambda$ of a light beam are represented by the expressions (1) and (1'), respectively.

In the present embodiment, both of the diffraction gratings GBS11 and GBS13 formed on the glass substrate G11 are transmissive diffraction gratings. Both of the diffraction gratings GBS12 and GBS14 formed on the glass substrate G12 are reflective diffraction gratings. Although the wavelength shift detector WLCD3 is made by the same manufacturing method as that of Embodiment 2, the transmissive diffraction grating and the reflective diffraction grating are strictly different in a microstructure such as a step. In particular, the transmissive diffraction grating is different from the reflective diffraction grating in depth of a grating. Therefore, according to the present embodiment, forming the diffraction grating structure is easier than that of Embodiment 2.

As described above, because the wavelength shift measuring apparatus of the present embodiment is also configured to hold the optical path length difference of the two light beams stably constant, the wavelength shift of the light source can be measured with high accuracy.

Next, the configuration of an exposure apparatus embodying the present invention will be described. Any wavelength shift measuring apparatus of Embodiments 1 to 3 described above can be applied in the exposure apparatus described below.

Fig. 10 is a schematic configuration diagram of an exposure apparatus 100 in the present embodiment. The exposure apparatus 100 includes the interference measuring apparatus (wavelength shift measuring apparatus) described above.

Reference numeral 1 denotes an illumination apparatus. The illumination apparatus 1 constitutes an illumination optical system which illuminates a pattern of a reticle (original plate), and includes a light source and a shutter (not shown) inside it. Reference numeral 2 denotes a reticle (original plate). A circuit pattern is depicted on the reticle 2. The circuit pattern formed on the reticle 2 is projected onto a wafer 9 by illuminating light on the reticle 2 using the illumination apparatus 1.

Reference numeral 3 denotes a reticle stage (first stage). The reticle stage 3 is movable and is provided for mounting the reticle 2 on it to move the reticle 2. Reference numeral 4 denotes a reticle position measuring portion (interference measuring apparatus). The reticle position measuring portion 4 measures a position of the reticle 2 mounted on the reticle stage 3 (a position of the reticle stage 3). Reference numeral 5 denotes a projection exposure lens. The projection exposure lens 5 constitutes a projection optical system for exposure and projects the pattern of the reticle 2 onto the wafer (substrate).

Reference numeral 6 denotes a wafer stage (second stage). The wafer stage 6 mounts the wafer 9 (substrate) to be exposed and moves in an in-plane direction of the wafer 9 (x and y directions).

Reference numeral 7 denotes a laser interferometer (interference measuring apparatus) and measures a position of the wafer stage 6. Reference numeral 8 denotes a wafer chuck and it absorbs and holds the wafer 9. Reference numeral 10 denotes an auto focus unit and it measures a focal position of the wafer 9.

As described above, the exposure apparatus 100 of the present embodiment includes at least one interference measuring apparatus which measures at least one of the positions of the reticle stage 3 (reticle position measuring portion 4) and the wafer stage 6 (laser interferometer 7). One or more of interference measuring apparatuses of the exposure apparatus provided with the wavelength shift measuring apparatus described above.

A device (a semiconductor integrated circuit device, a liquid crystal display device, or the like) may be manufactured by a process of exposing a substrate (a wafer, a glass plate, or the like) to which a photosensitizing agent is applied using an exposure apparatus as described above, before developing the substrate using a process known in the art.

As described above, since the present embodiment includes a configuration where an optical path length difference of two light beams is stably constant, a shift of the light source wavelength can be measured. Therefore, a highly-accurate wavelength shift measuring apparatus, light source apparatus, interference measuring apparatus, and exposure apparatus can be provided. Further, a method for manufacturing a device using the above exposure apparatus can be provided.

According to the present embodiment, a highly-accurate and stable measuring apparatus can be realized by only adding an inexpensive and simple optical system and by detecting a shift of a light source wavelength to correct a measured value.

For example, for the measurement of the wavelength shift, a light beam having a wavelength of 850nm enters a Michelson interferometer in which an optical path length difference of two light beams is fixed at 10mm. When an interference phase shift is measured with a resolution of 1/4096 period, a wavelength shift of 0.018pm can be measured. In this case, when the optical path length difference of the two light beams is 5mm in a main interference measuring apparatus, the measured value can be corrected with a step of 0.1nm. Therefore, even if the light source wavelength varies, an error of the measured value can be reduced to 0.1nm or less.

A wavelength shift measuring apparatus in the present embodiment is also applicable to, for example, an industrial machine stage which needs to detect a subnanometer displacement, a highly-accurate shape measuring apparatus, a microscope stage, a highly-accurate machining apparatus and a semiconductor manufacturing apparatus. Further, a wavelength shift sensor is particularly applicable to an apparatus which measures a wavelength shift caused by change of the passage of time of a laser diode to predict its lifetime.

In a particular embodiment the wavelength shift detecting apparatus of the invention(WLCD; WLCD1; WLCD2; WLCD3) detects a shift of a wavelength of a source light beam emitted from a light source (LD), and the wavelength shift detecting apparatus comprises:

an optical system (PBS2, CC2, CC3, QWP, POL1, POL2, GBS1, GBS2, GBS3, GBS4, GBS11, GBS12, GBS13, GBS14, R1, R2) configured to split the source light beam into at least a first light beam and a second light beam and to direct the first light beam along a first optical path and the second light beam along a second optical path wherein the difference between the optical path lengths is constant, before synthesizing the two light beams to generate an interference pattern;

at least one photoelectric sensor (PD) configured to detect the interference pattern generated by the optical system, wherein the at least one photoelectric sensor (PD) outputs at least one interference signal (cos ωt, sin ωt) based on the interference pattern generated by the synthesized light beams, the at least one interference signal representing a wavelength shift of the light source (LD).

The optical system preferably comprises a polarization beam splitter (PBS2) arranged to split the source light beam into a transmitted light beam and a reflected light beam, a first corner cube (CC2) arranged to reflect the reflected light beam back to the polarization beam splitter, and a second corner cube (CC3) arranged to reflect the transmitted light beam back to the polarization beam splitter, such that the polarization beam splitter synthesizes the reflected and transmitted light beams.

A spacer member (SP) is preferably positioned between the polarization beam splitter (PBS2) and the first corner cube (CC2).

The optical system preferably comprises a first diffraction grating (GBS1, GBS11) configured to split the source light beam into two light beams and a second diffraction grating (GBS4, GBS13) configured to synthesize the two light beams to generate an interference pattern.

The first and second diffraction gratings are preferably transmissive diffraction gratings.

The first diffraction grating is preferably provided on a first plate (G1), and the second diffraction grating is provided on a second plate (G2), wherein the first and second plates are arranged to face each other.

A spacer member (SP) is preferably positioned between the first and second plates.

The first (G1) and second plates (G2) are preferably each further provided with a reflective diffraction grating (GBS3, GBS2).

The first and second diffraction gratings are preferably transmissive diffraction gratings and are preferably both provided on a first plate (G11).

The first plate (G11) is preferably further provided with a first reflective element (R1) positioned between the first and second transmissive diffraction gratings and the optical system preferably further comprises a second plate (G12), wherein the second plate is provided with two reflective diffraction gratings (GBS12, GBS14) and a second reflective element (R2) positioned between the two reflective diffraction gratings and further wherein the second plate is positioned to face the first plate.

A spacer member (SP) is preferably positioned between the first and second plates.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

**1.** A wavelength shift measuring apparatus (WLCD; WLCD1; WLCD2; WLCD3) which measures a shift of a wavelength of a light beam emitted from a light source (LD), the wavelength shift measuring apparatus comprising:

an optical system (PBS2, CC2; GBS1 to GBS4; GBS11 to 14, R1, R2) configured to split the light beam emitted from the light source into a plurality of light beams and to synthesize two light beams among the plurality of light beams to generate an interference light;
a spacer member (SP) provided so that an optical path length difference of the two light beams split by the optical system is constant; and
a plurality of photoelectric sensors (PDA+, PDB+) configured to detect the interference light generated by the optical system and to output a plurality of interference signals (cos ωt, sin ωt) which have phases shifted from each other based on the interference light; and
a wavelength shift measuring portion configured to calculate the shift of the wavelength of the light beam, based on the plurality of interference signals outputted from the plurality of the photoelectric sensors.

**2.** A wavelength shift measuring apparatus according to claim 1,
**characterized in that**
the optical system includes a polarization beam splitter (PBS2) and a corner cube (CC2),
the spacer member (SP) holds an interval between the polarization beam splitter and the corner cube,
the light beam emitted from the light source (LD) is split into the two light beams constituted of reflected light and transmitted light by the polarization beam splitter (PBS2), and
the interference light is generated by reflecting the reflected light by the corner cube (CC2) and by synthesizing the reflected light and the transmitted light.

**3.** A wavelength shift measuring apparatus according to claim 1,
**characterized in that**
the optical system includes a first diffraction grating plate (G1) on which a first diffraction grating (GBS1, GBS3) splitting the light beam into the two light beams is provided and a second diffraction grating plate (G2) on which a second diffraction grating (GBS2, GBS4) is provided, the second diffraction grating plate being arranged so as to face the first diffraction grating plate,
the spacer member (SP) holds an interval between the first diffraction grating plate (G1) and the second diffraction grating plate (G2) so that the optical path length difference of the two light beams is constant, and
the interference light is generated by synthesizing the two light beams by the second diffraction grating (GBS2, GBS4).

**4.** A wavelength shift measuring apparatus according to claim 1,
**characterized in that**
the optical system includes a first diffraction grating plate (G11) which is provided with a first diffraction grating (GBS11, GBS13) splitting the light beam into the two light beams and a first reflective element (R1), and a second diffraction grating plate (G12) which is provided with a second diffraction grating (GBS12, GBS14) and a second reflective element (R2), the second diffraction grating plate being arranged so as to face the first diffraction grating plate,
the spacer member (SP) holds an interval between the first diffraction grating plate (G11) and the second diffraction grating plate (G12) so that the optical path length difference of the two light beams is constant,
one of the two light beams are reflected by the first reflective element (R1),
the other of the two light beams are reflected by the second reflective element (R2), and
the interference light is generated by synthesizing reflected light by the first reflective element (R1) and reflected light by the second reflective element (R2) using the first diffraction grating (GBS11, GBS13).

**5.** A light source apparatus which emits a coherent light beam, the light source apparatus comprising:

a light source (LD) configured to emit the light beam;
a light beam splitting portion (BS1) configured to split the light beam emitted from the light source;
a wavelength shift measuring apparatus (WLCD; WLCD1; WLCD2; WLCD3) according to any one of claims 1 to 4, the wavelength shift measuring apparatus being configured to receive a part of a light beam split by the light beam splitting portion and output a plurality of interference signals based on the light beam; and
a controller (PROCESSOR2, DRIVER) configured to control a driving current and a temperature of the light source so as to suppress a wavelength shift of the light beam emitted from the light source, based on the plurality of interference signals outputted from the wavelength shift measuring apparatus.

**6.** An interference measuring apparatus which measures a displacement of an object to be measured, the interference measuring apparatus comprising:

a light source (LD) configured to emit a coherent light beam;
an interference measuring portion (4, 7) configured to receive a part of the light beam emitted from the light source to measure the displacement of the object to be measured;
a wavelength shift measuring apparatus (WLCD; WLCD1; WLCD2; WLCD3) according to any one of claims 1 to 4, the wavelength shift measuring apparatus being configured to receive the other part of the light beam emitted from the light source to output a plurality of interference signals based on the light beam; and
a displacement correcting portion (PROCESSOR; PROCESSOR2) configured to correct the displacement of the object to be measured which has been measured by the interference measuring portion using the shift of the wavelength calculated by the wavelength shift calculating portion.

**7.** An exposure apparatus (100) which exposes a pattern of an original plate (2) onto a substrate (9), the exposure apparatus comprising:

an illumination optical system (1) configured to illuminate the pattern of the original plate;
a projection optical system (5) configured to project the pattern of the original plate onto the substrate;
a first stage (3) configured to move while mounting the original plate;
a second stage (6) configured to move while mounting the substrate; and
an interference measuring apparatus (4, 7) according to claim 6, the interference measuring apparatus being configured to measure at least one of positions of the first and second stages.

**8.** A device manufacturing method comprising the steps of:

exposing the substrate (9) using an exposure apparatus (100) according to claim 7; and
developing the exposed substrate.

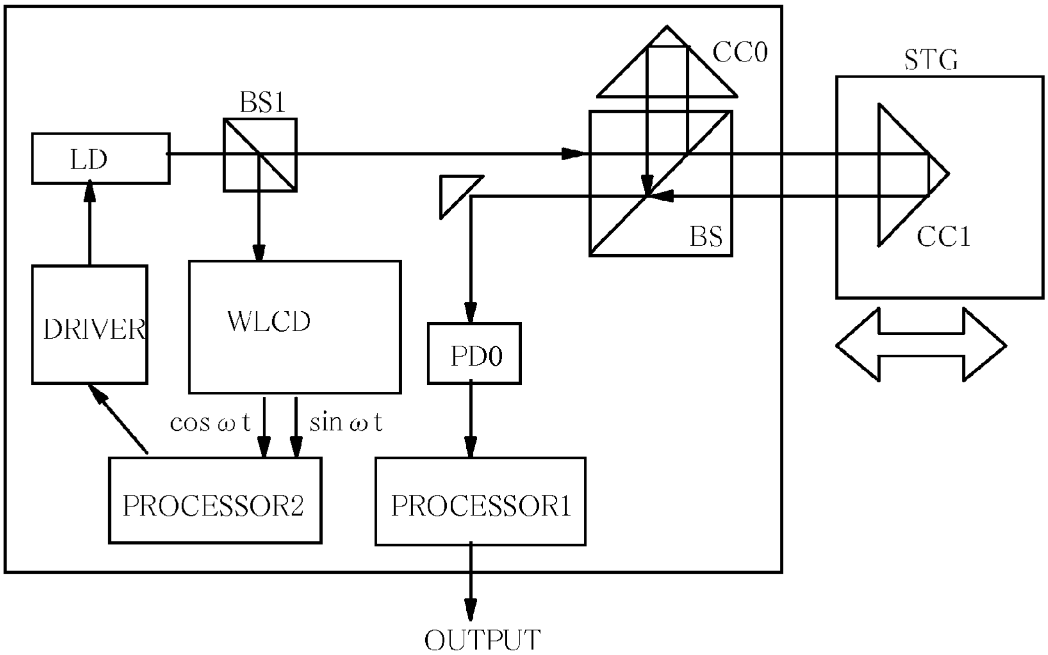
CC0
STG
BS1
LD
BS
CC1
DRIVER
WLCD
PD0
cos ω t
sin ω t
PROCESSOR2
PROCESSOR1
OUTPUT

FIG. 1

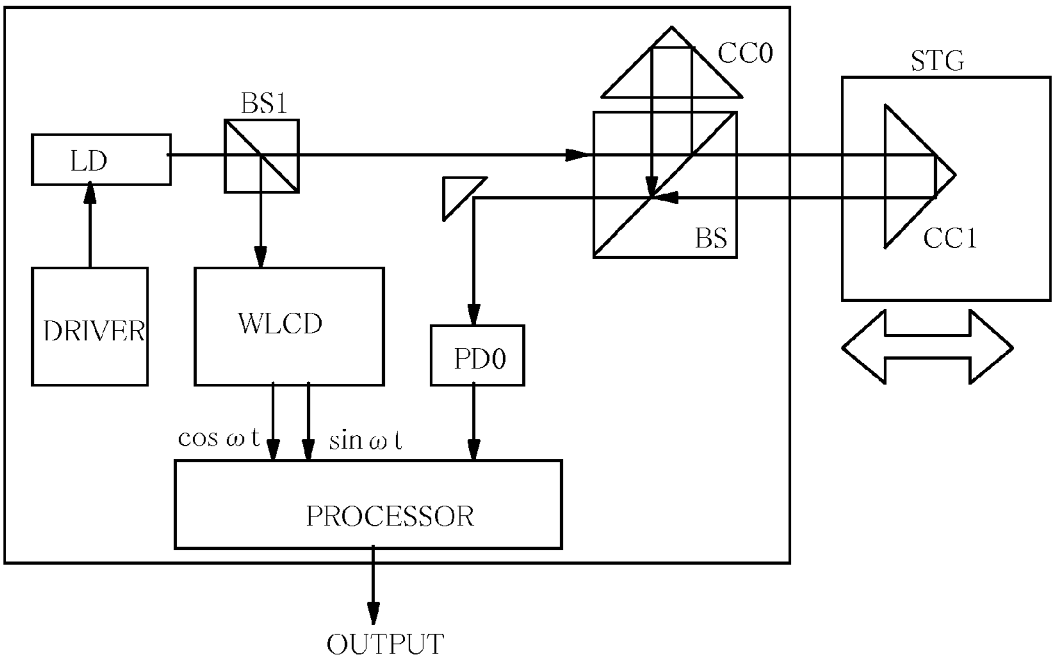
CC0
STG
BS1
LD
BS
CC1
DRIVER
WLCD
PD0
cos ω t
sin ω t
PROCESSOR
OUTPUT

FIG. 2

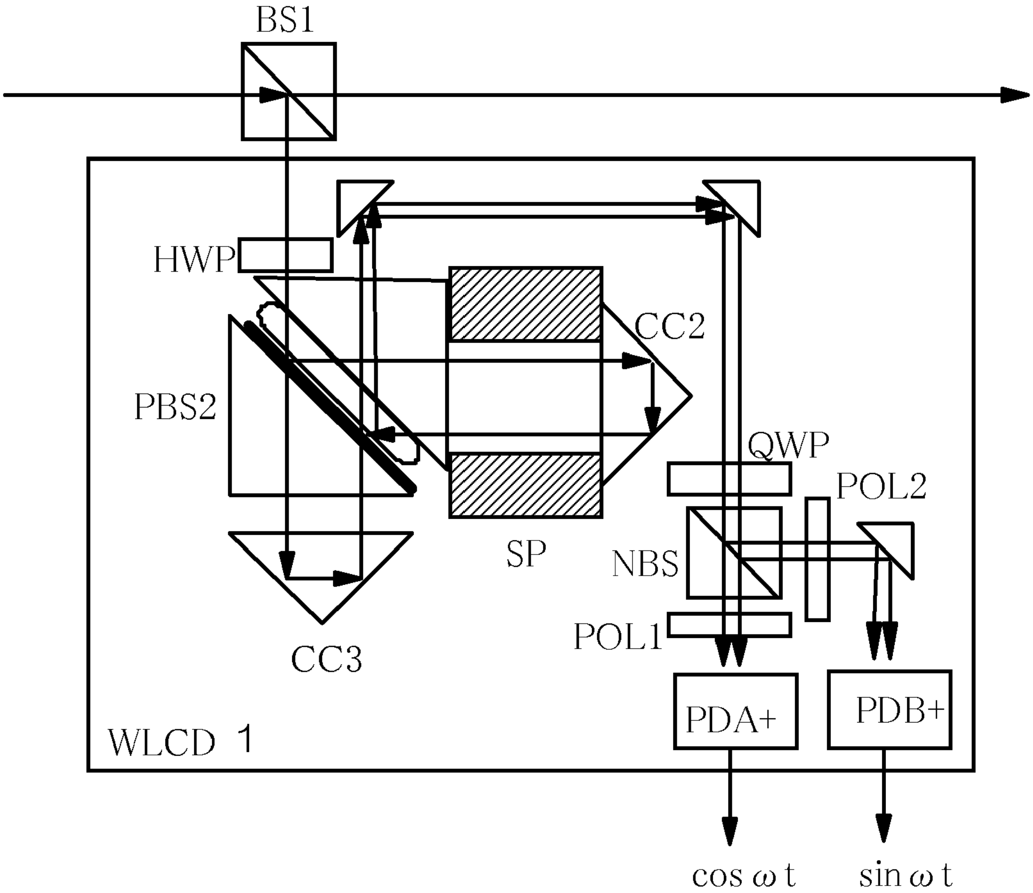
BS1
HWP
PBS2
CC2
SP
CC3
QWP
POL2
NBS
POL1
PDA+
PDB+
WLCD 1
cos ω t
sin ω t

FIG. 3

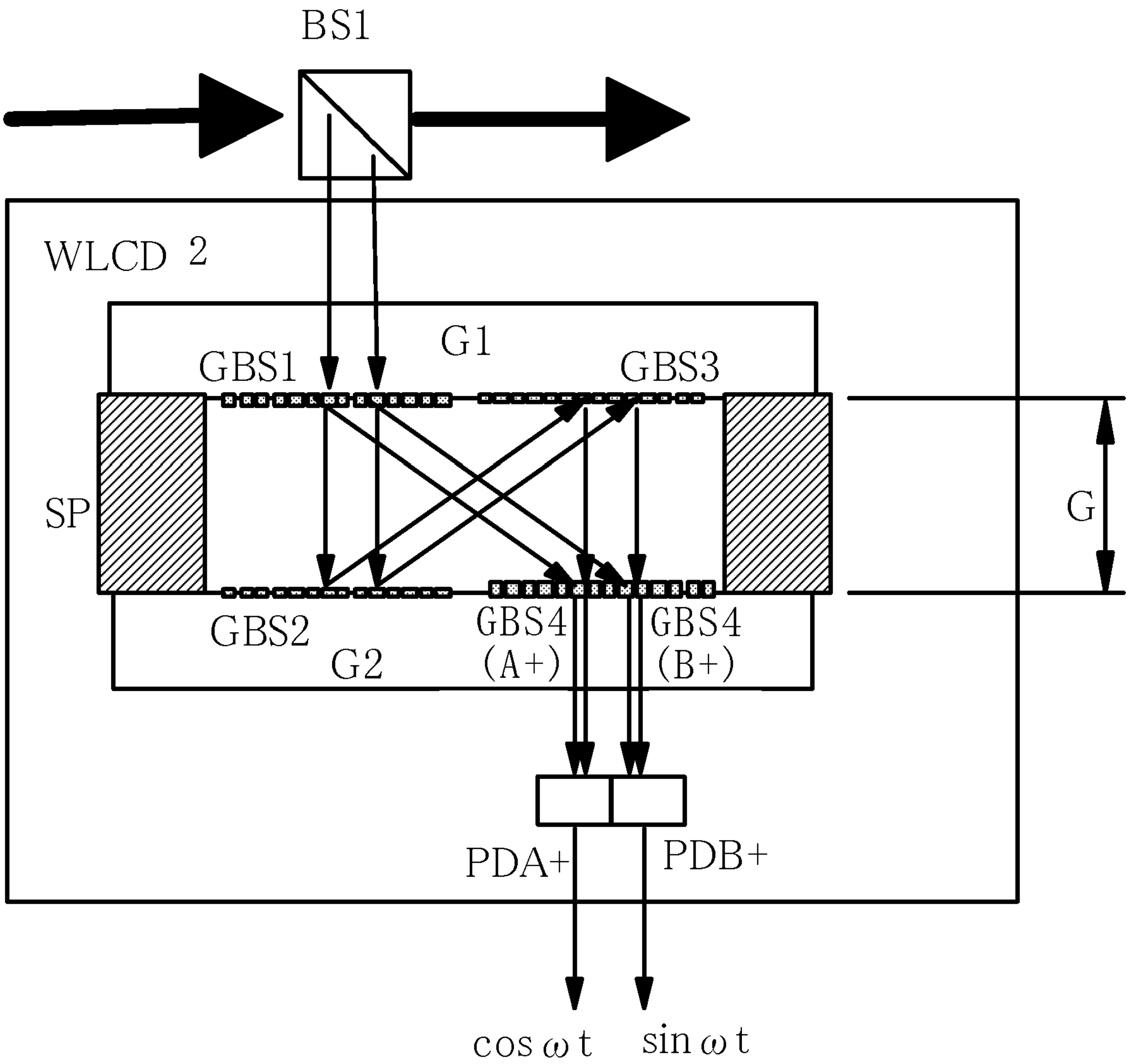
BS1
WLCD 2
G1
GBS1
GBS3
SP
G
GBS2
G2
GBS4
(A+)
GBS4
(B+)
PDA+
PDB+
cos ω t
sin ω t

FIG. 4

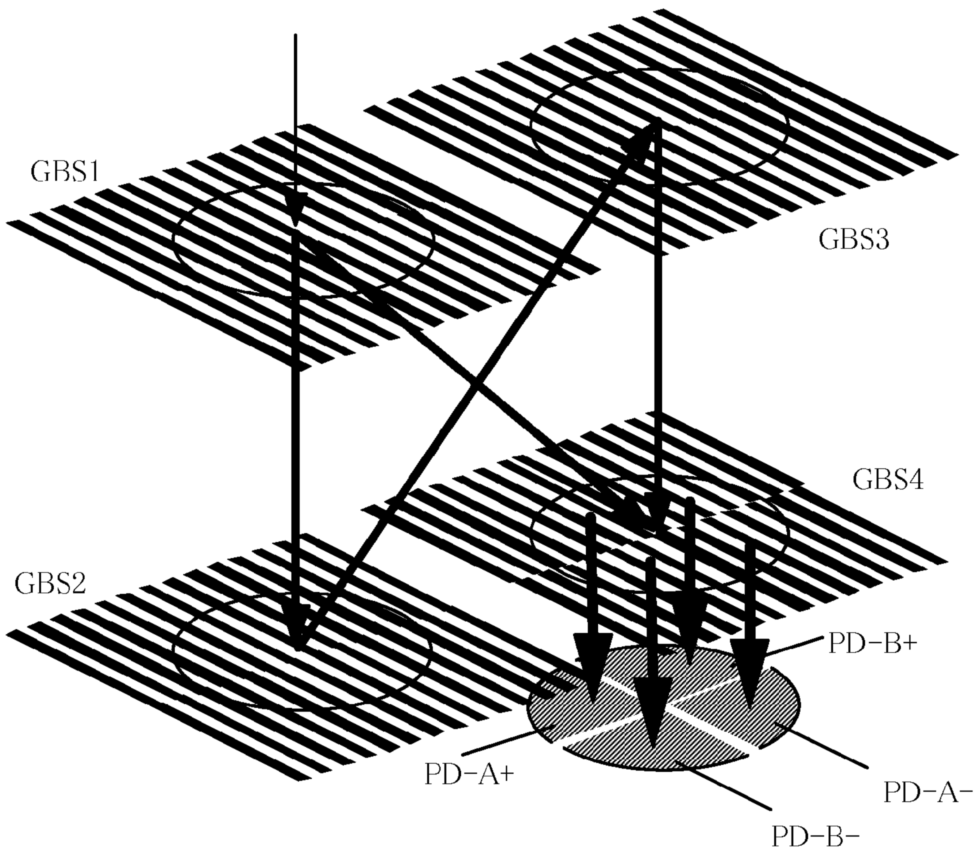


FIG. 5

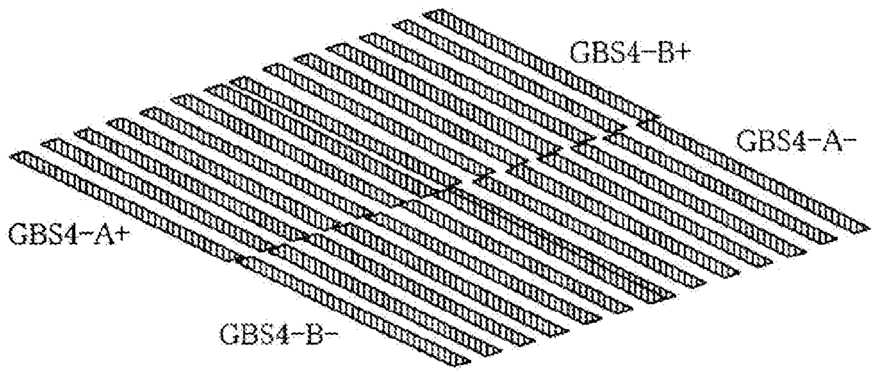


FIG. 6

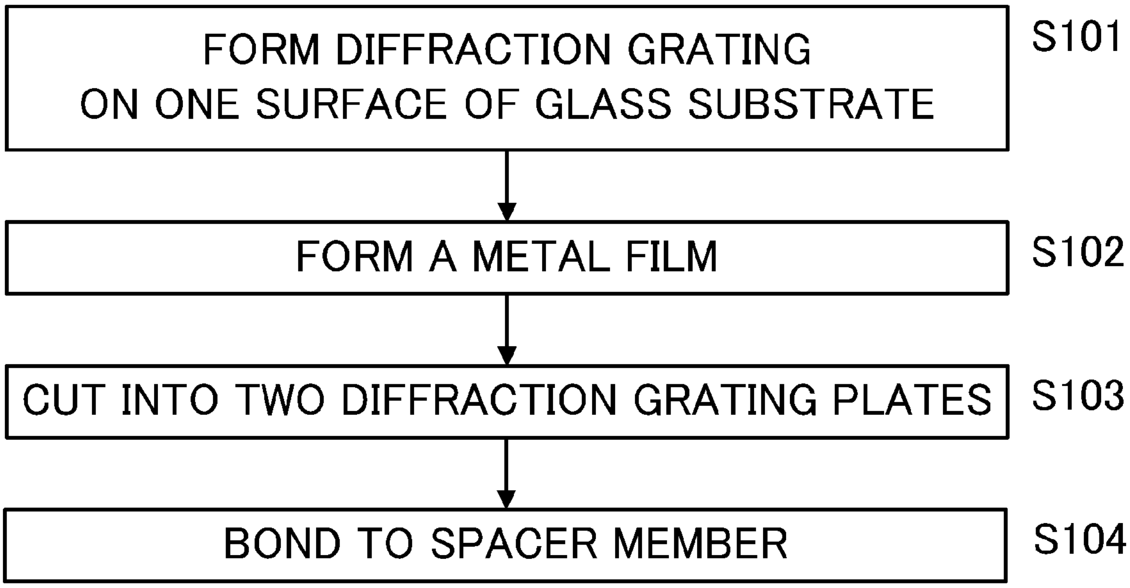
FORM DIFFRACTION GRATING ON ONE SURFACE OF GLASS SUBSTRATE
S101
FORM A METAL FILM
S102
CUT INTO TWO DIFFRACTION GRATING PLATES
S103
BOND TO SPACER MEMBER
S104

FIG. 7

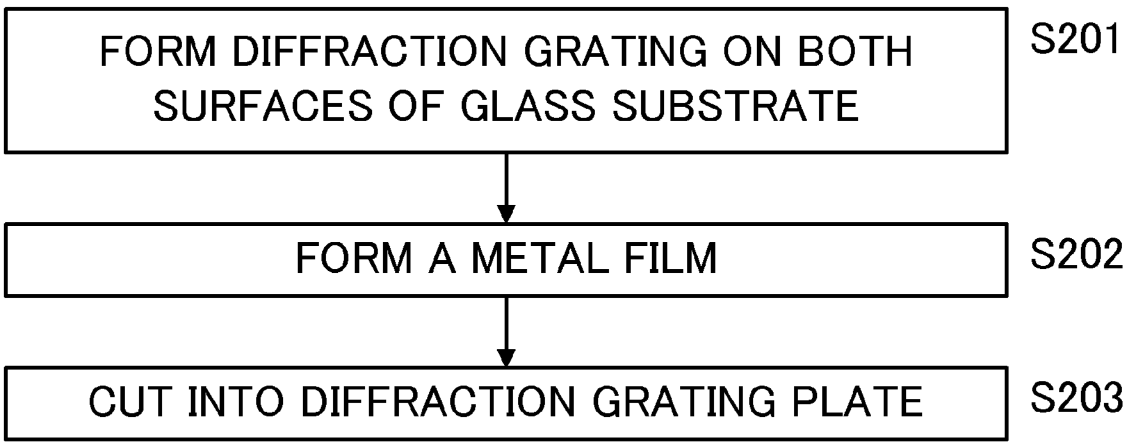
FORM DIFFRACTION GRATING ON BOTH SURFACES OF GLASS SUBSTRATE
S201
FORM A METAL FILM
S202
CUT INTO DIFFRACTION GRATING PLATE
S203

FIG. 8

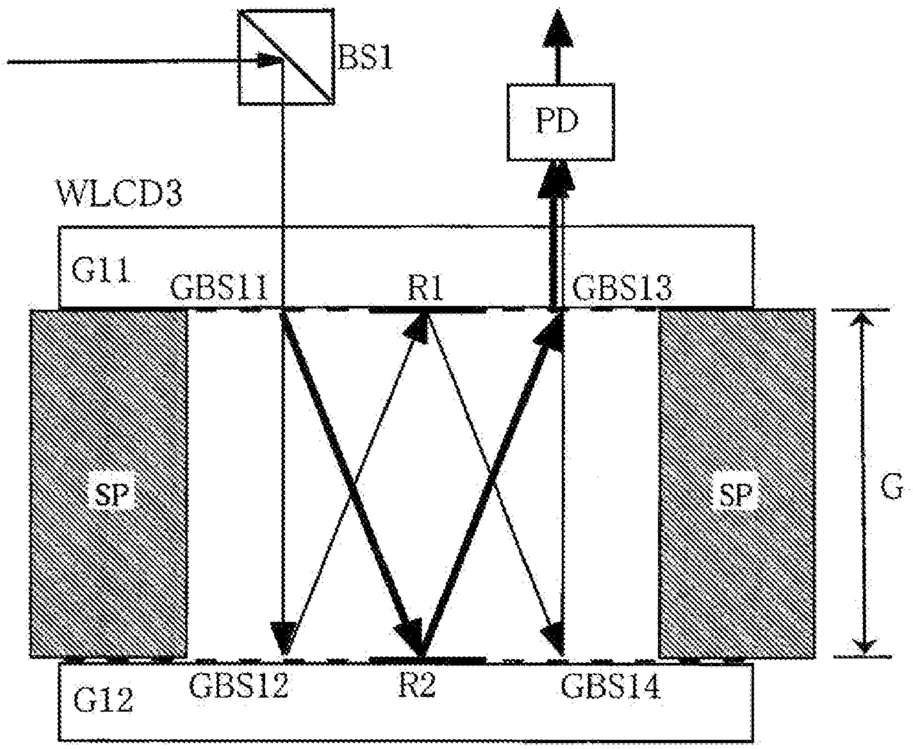


FIG. 9

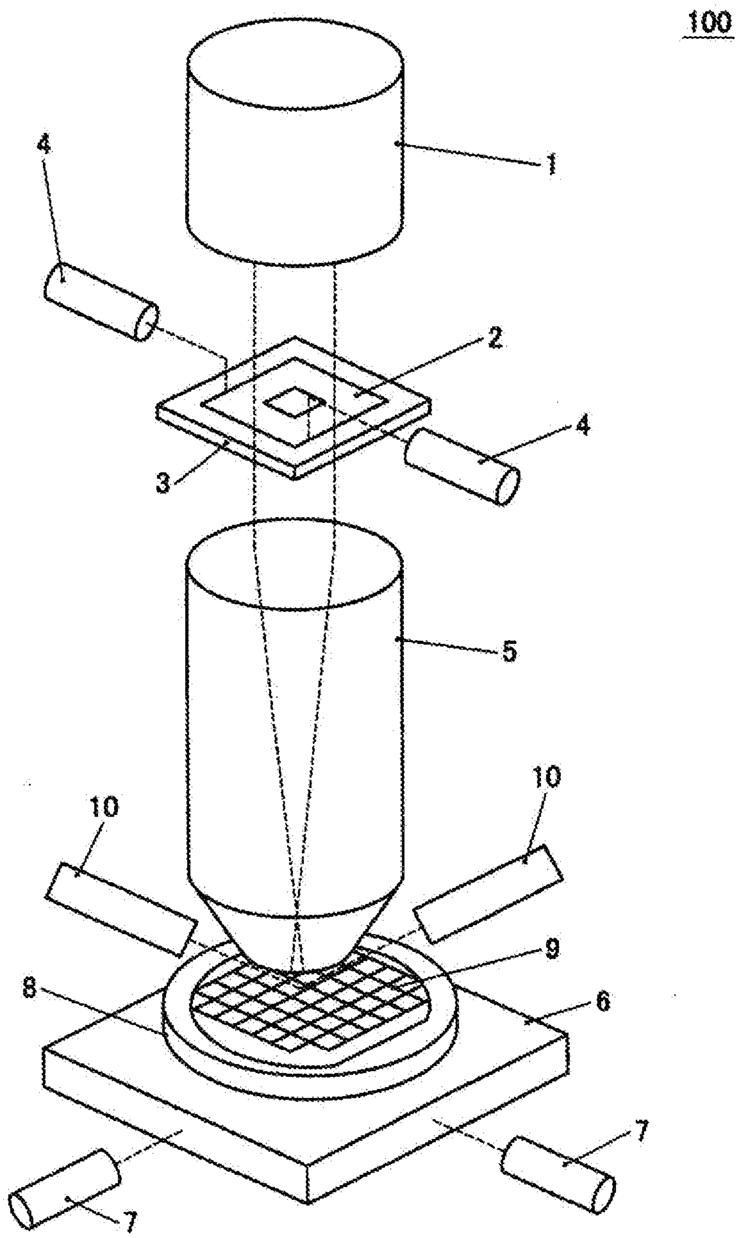


FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002319737 A
- JP 2003202203 A
- JP 2006010499 A